# EUROPÄISCHE PATENTANMELDUNG

(11) **EP 3 562 277 A1**
(43) Veröffentlichungstag der Anmeldung: **30.10.2019**
(21) Anmeldenummer: 18169238.5
(22) Anmeldetag: 25.04.2018
(51) Int. Cl.: H05K 3/12, B41F 15/08

(54) **HERSTELLUNG EINER LEITERBAHN AUF EINER TRÄGERPLATTE**

(71) Anmelder: Siemens Aktiengesellschaft, 80333 München (DE)
(72) Erfinder: Burger, Josef, 92546 Schmidgaden (DE); Pöhler, Dirk, 08056 Zwickau (DE); Sertl, Daniel, 95506 Kastl (DE); Wilke, Klaus, 12527 Berlin (DE)

(57) **Zusammenfassung**

Die Erfindung betrifft ein Verfahren und eine Fertigungsvorrichtung zur Herstellung einer Leiterbahn (3) auf einer Trägerplatte (1). Bei dem Verfahren werden ein Widerstandswert für einen elektrischen Widerstand der Leiterbahn (3) und ein Leiterbahnverlauf der Leiterbahn (3) auf der Trägerplatte (1) vorgegeben. Entlang des vorgegebenen Leiterbahnverlaufs wird eine elektrisch leitfähige Paste (4) auf die Trägerplatte (1) aufgebracht und durch Erwärmung vorgehärtet. Anschließend wird die vorgehärtete Paste (4) ausgehärtet, indem sie elektrisch bestromt wird. Während des Bestromens der Paste (4) wird fortlaufend ein elektrischer Widerstand der aushärtenden Paste (4) erfasst und die Bestromung wird beendet, wenn der erfasste elektrische Widerstand den vorgegebenen Widerstandswert erreicht.

## Beschreibung

Die Erfindung betrifft ein Verfahren und eine Fertigungsvorrichtung zur Herstellung einer Leiterbahn auf einer Trägerplatte. Ferner betrifft die Erfindung eine Backplane zum elektrischen Verbinden elektrischer Bauelemente und einen Schaltschrank.

Unter einer Backplane wird hier ein Träger für elektrische Bauelemente verstanden, der Leiterbahnen zum elektrischen Verbinden der elektrischen Bauelemente aufweist. Derartige elektrische Bauelemente sind beispielsweise Niederspannungsschaltgeräte wie Schütze, Motorschutzschalter, Motorstarter, Sanftstarter oder Relais, oder Steuerungseinheiten oder Eingabe-/Ausgabeeinheiten.

Bei bekannten Verfahren zum Herstellen von Leiterbahnstrukturen konventioneller Leiterplatten werden die Leiterbahnen durch lithografische und ätztechnische Verfahren aus einer geschlossenen Kupferoberfläche herausgearbeitet.

In einem Schaltschrank werden elektrische Bauelemente einer technischen Vorrichtung oder Anlage angeordnet. In herkömmlichen Schaltschränken werden elektrische Bauelemente in der Regel durch Kabel elektrisch miteinander verbunden. Bei einer Vielzahl elektrischer Bauelemente entsteht dabei ein hoher Verkabelungsaufwand.

DE 10 2016 002 052 A1 offenbart einen Schaltschrank und ein Verfahren zu dessen Herstellung. Der Schaltschrank weist zumindest eine Schalttafel mit einer Grundplatte auf, auf der elektrische Schaltelemente angeordnet und miteinander elektrisch verbunden sind. Die zumindest eine Grundplatte und/oder zumindest eines der Schaltelemente wird mittels eines 3D-Druckers in einem 3D-Druckverfahren hergestellt.

Der Erfindung liegt die Aufgabe zugrunde, ein verbessertes Verfahren und eine verbesserte Fertigungsvorrichtung zum Herstellen einer Leiterbahn auf einer Trägerplatte, insbesondere für eine Backplane eines Schaltschranks, anzugeben.

Die Aufgabe wird erfindungsgemäß durch ein Verfahren mit den Merkmalen des Anspruchs 1 und eine Fertigungsvorrichtung mit den Merkmalen des Anspruchs 6 gelöst.

Vorteilhafte Ausgestaltungen der Erfindung sind Gegenstand der abhängigen Ansprüche.

Bei dem erfindungsgemäßen Verfahren zur Herstellung einer Leiterbahn auf einer Trägerplatte werden ein Widerstandswert für einen elektrischen Widerstand der Leiterbahn und ein Leiterbahnverlauf der Leiterbahn auf der Trägerplatte vorgegeben. Entlang des vorgegebenen Leiterbahnverlaufs wird eine elektrisch leitfähige Paste auf die Trägerplatte aufgebracht und durch Erwärmung vorgehärtet. Anschließend wird die vorgehärtete Paste ausgehärtet, indem sie elektrisch bestromt wird. Während des Bestromens der Paste wird fortlaufend ein elektrischer Widerstand der aushärtenden Paste erfasst und die Bestromung wird beendet, wenn der erfasste elektrische Widerstand den vorgegebenen Widerstandswert erreicht.

Die Erfindung sieht also vor, eine Leiterbahn auf einer Trägerplatte herzustellen, indem eine elektrisch leitfähige Paste auf die Trägerplatte entlang eines vorgegebenen Leiterbahnverlaufs aufgebracht und in einem zweistufigen Prozess gehärtet wird. Zum Härten wird die Paste zunächst durch Erwärmung nur vorgehärtet, so dass die Paste stabil bei der Kontaktierung der Paste mit einem Kontaktelement ist. Anschließend wird die Paste durch Bestromung ausgehärtet bis ihr elektrischer Widerstand einen vorgegebenen Widerstandswert erreicht. Dabei wird ausgenutzt, dass die Bestromung die Paste erwärmt und dadurch aushärtet. Durch das Aushärten der Paste mittels der Bestromung und das gleichzeitige Erfassen des elektrischen Widerstands der aushärtenden Paste wird das Aushärten der Paste mit einem elektrischen Funktionstest der Leiterbahn kombiniert, da die Beendigung der Bestromung durch das Erreichen eines elektrischen Widerstands getriggert wird, der für die Leiterbahn vorgegeben wird. Durch die Kombination des Aushärtens mit dem elektrischen Funktionstest der Leiterbahn kann eine separate Funktionsprüfung der Leiterbahn vorteilhaft entfallen.

Eine Ausgestaltung des Verfahrens sieht vor, dass die elektrisch leitfähige Paste mit einem additiven Fertigungsverfahren, beispielsweise mit einem 3D-Druck, auf die Trägerplatte aufgebracht wird.

Unter einem 3D-Druck wird ein Verfahren verstanden, bei dem ein dreidimensionales Objekt durch computergesteuertes schichtweises Auftragen von Material hergestellt wird. Die vorgenannte Ausgestaltung der Erfindung berücksichtigt, dass unterschiedliche Konfigurationen elektrisch zu verbindender Bauelemente auch unterschiedliche Querschnitte und Verläufe der Leiterbahnen erfordern. Beispielsweise sind für leistungsführende Leitungen dickere Leiterbahnen als für Signalleitungen erforderlich, und unterschiedliche Anordnungen der Bauelemente erfordern unterschiedliche Verläufe der Leiterbahnen. Die Fertigung der Leiterbahnen mit einem 3D-Druck ermöglicht, die Querschnitte und die Verläufe der Leiterbahnen in einfacher Weise flexibel der Konfiguration der jeweils elektrisch zu verbindenden Bauelemente anzupassen.

Eine weitere Ausgestaltung des Verfahrens sieht vor, dass die auf die Trägerplatte aufgebrachte Paste mit elektromagnetischer Strahlung, beispielsweise mit einem Laserstrahl, entlang des Leiterbahnverlaufs vorgehärtet wird. Die Verwendung eines Laserstrahls ermöglicht vorteilhaft einen lokal auf den Bereich der Paste begrenzten Wärmeeintrag zum Vorhärten der Paste.

Eine weitere Ausgestaltung des Verfahrens sieht vor, dass die Paste zum Bestromen mit zwei bewegbaren elektrisch leitfähigen Kontaktelementen kontaktiert wird, zwischen denen eine elektrische Spannung angelegt wird. Die Verwendung zweier bewegbarer Kontaktelemente zum Bestromen der Paste ermöglicht, die Kontaktelemente flexibel zu verschiedenen Punkten der Trägerplatte zu bewegen und damit die Positionen der Kontaktelemente dem Leiterbahnverlauf anzupassen.

Eine erfindungsgemäße Fertigungsvorrichtung zur Herstellung einer Leiterbahn auf einer Trägerplatte gemäß dem erfindungsgemäßen Verfahren umfasst einen Drucker zum Drucken der elektrisch leitfähigen Paste auf die Trägerplatte, einen Vorhärter zum Vorhärten auf die Trägerplatte gedruckter Paste, eine Bestromungsvorrichtung zum Bestromen einer auf die Trägerplatte gedruckten vorgehärteten Paste, eine Messvorrichtung zum Erfassen eines elektrischen Widerstands der auf die Trägerplatte gedruckten Paste während des Bestromens der Paste und eine Steuereinheit zum Steuern des Druckers, des Vorhärters und der Bestromungsvorrichtung.

Eine erfindungsgemäße Fertigungsvorrichtung ermöglicht die Herstellung einer Leiterbahn mit dem erfindungsgemäßen Verfahren. Die Vorteile der Fertigungsvorrichtung entsprechen daher den oben genannten Vorteilen des erfindungsgemäßen Verfahrens.

Eine Ausgestaltung der Fertigungsvorrichtung sieht vor, dass der Drucker ein 3D-Drucker ist.

Eine weitere Ausgestaltung der Fertigungsvorrichtung sieht vor, dass der Vorhärter eine Strahlungsquelle elektromagnetischer Strahlung, beispielsweise einen Laser, zum Bestrahlen der Paste mit elektromagnetischer Strahlung entlang des vorgegebenen Leiterbahnverlaufs aufweist.

Eine weitere Ausgestaltung der Fertigungsvorrichtung sieht vor, dass die Bestromungsvorrichtung zum Kontaktieren einer auf die Trägerplatte gedruckten vorgehärteten Paste zwei bewegbare elektrisch leitfähige Kontaktelemente aufweist, zwischen denen eine elektrische Spannung anlegbar ist.

Die vorgenannten Ausgestaltungen und Vorteile der Fertigungsvorrichtung entsprechen oben genannten Ausgestaltungen und Vorteilen des erfindungsgemäßen Verfahrens.

Eine weitere Ausgestaltung der Fertigungsvorrichtung sieht vor, dass mit der Steuereinheit der Widerstandswert für den elektrischen Widerstand der Leiterbahn und der Leiterbahnverlauf der Leiterbahn auf der Trägerplatte vorgebbar sind, der Drucker zum Drucken der elektrisch leitfähigen Paste entlang des vorgegebenen Leiterbahnverlaufs auf die Trägerplatte steuerbar ist, der Vorhärter zum Vorhärten der auf die Trägerplatte gedruckten Paste entlang des vorgegebenen Leiterbahnverlaufs steuerbar ist und die Bestromungsvorrichtung zum Bestromen der auf die Trägerplatte gedruckten vorgehärteten Paste steuerbar ist, wobei die Bestromung der Paste beendet wird, wenn der von der Messvorrichtung erfasste elektrische Widerstand der Paste den vorgegebenen Widerstandswert erreicht. Diese Funktionen können insbesondere durch ein von der Streuereinheit ausgeführtes Steuerprogramm, insbsondere durch ein Computerprogramm, realisiert sein.

Eine erfindungsgemäße Backplane zum elektrischen Verbinden elektrischer Bauelemente umfasst eine Trägerplatte mit einer Leiterbahn, die mit dem erfindungsmäßen Verfahren gefertigt ist. Ein erfindungsgemäßer Schaltschrank weist eine erfindungsgemäße Backplane auf. Die Verwendung einer erfindungsgemäßen Backplane in einem Schaltschrank reduziert vorteilhaft den Aufwand und die Kosten zum elektrischen Verbinden elektrischer Bauelemente in dem Schaltschrank gegenüber dem herkömmlichen Verbinden elektrischer Bauelemente durch Kabel. Weitere Vorteile einer erfindungsgemäßen Backplane und eines erfindungsgemäßen Schaltschranks ergeben sich aus den oben genannten Vorteilen des erfindungsgemäßen Verfahrens.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: eine Draufsicht auf eine Trägerplatte mit einer Leiterbahn,
- FIG 2: ein Ablaufdiagramm eines Verfahrens zur Herstellung einer Leiterbahn auf einer Trägerplatte,
- FIG 3: schematisch eine Bestromungsvorrichtung zum Bestromen einer auf eine Trägerplatte gedruckten vorgehärteten Paste und eine Messvorrichtung zum Erfassen eines elektrischen Widerstands der Paste,
- FIG 4: schematisch eine Fertigungsvorrichtung zur Herstellung einer Leiterbahn auf einer Trägerplatte,
- FIG 5: eine perspektivische Darstellung eines Schaltschranks.

Einander entsprechende Teile sind in den Figuren mit denselben Bezugszeichen versehen.

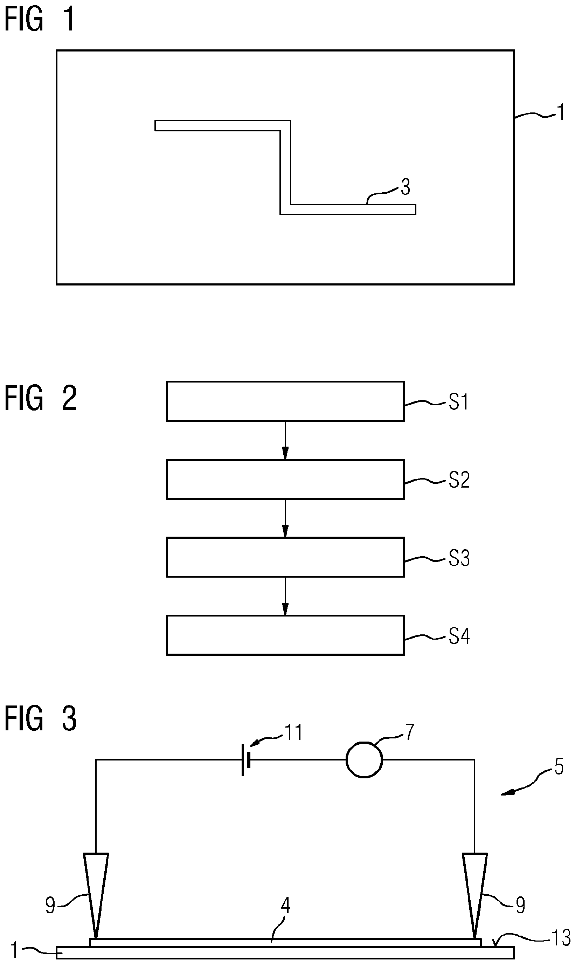

Figur 1 zeigt eine Draufsicht auf eine Trägerplatte 1 mit einer mit dem erfindungsgemäßen Verfahren hergestellten Leiterbahn 3.

Figur 2 zeigt ein Ablaufdiagramm des erfindungsgemäßen Verfahrens zur Herstellung einer Leiterbahn 3 auf einer Trägerplatte 1.

In einem ersten Verfahrensschritt S1 werden ein Widerstandswert für einen elektrischen Widerstand der Leiterbahn 3 und ein Leiterbahnverlauf der Leiterbahn 3 auf der Trägerplatte 1 vorgegeben.

In einem zweiten Verfahrensschritt S2 wird eine elektrisch leitfähige Paste 4, beispielsweise eine Kupfer-, Aluminium-, Messing- oder Silberpaste, entlang des vorgegebenen Leiterbahnverlaufs auf die Trägerplatte 1 gedruckt. Beispielsweise wird die Paste 4 mit einem 3D-Druck auf die Trägerplatte 1 gedruckt.

In einem dritten Verfahrensschritt S3 wird die auf die Trägerplatte 1 gedruckte Paste 4 vorgehärtet. Beispielsweise wird die auf die Trägerplatte 1 gedruckte Paste 4 mit elektromagnetischer Strahlung vorgehärtet, z. B. mit einem Laserstrahl, der entlang des Leiterbahnverlaufs über die Paste 4 geführt wird und die Paste 4 dabei erwärmt und dadurch vorhärtet.

In einem vierten Verfahrensschritt S4 wird die vorgehärtete Paste 4 ausgehärtet, indem sie elektrisch bestromt wird. Dabei wird fortlaufend ein elektrischer Widerstand der aushärtenden Paste 4 erfasst. Die Bestromung wird beendet, wenn der erfasste elektrische Widerstand den vorgegebenen Widerstandswert erreicht.

Figur 3 zeigt schematisch eine Bestromungsvorrichtung 5 zum Bestromen einer auf eine Trägerplatte 1 gedruckten vorgehärteten Paste 4 und eine Messvorrichtung 7 zum Erfassen eines elektrischen Widerstands der Paste 4 während des Bestromens in dem vierten Verfahrensschritt S4.

Die Bestromungsvorrichtung 5 umfasst zwei elektrisch leitfähige Kontaktelemente 9 und eine Spannungsquelle 11, mit der eine elektrische Spannung zwischen den Kontaktelementen 9 anlegbar ist. Statt einer Spannungsquelle 11 kann auch eine Stromquelle vorgesehen sein. Die Kontaktelemente 9 sind über einer mit der Paste 4 bedruckten Oberfläche 13 der Trägerplatte 1 angeordnet und jeweils dreidimensional bewegbar, so dass jedes Kontaktelement 9 zu jedem Punkt der Oberfläche 13 der Trägerplatte 1 bewegt werden kann. Zum Bestromen einer entlang eines Leiterbahnverlaufs auf die Trägerplatte 1 gedruckten und vorgehärteten Paste 4 wird jedes Kontaktelement 9 zu einem Endbereich des Leiterbahnverlaufs bewegt und die Paste 4 wird in dem Endbereich von dem Kontaktelement 9 kontaktiert. Nach dem Kontaktieren der Paste 4 durch die Kontaktelemente 9 wird die Paste 4 bestromt, indem eine elektrische Spannung zwischen den Kontaktelementen 9 angelegt wird. Die Kontaktelemente 9 sind beispielsweise als Messspitzen oder Messstempel zum Kontaktieren der Paste 4 ausgeführt.

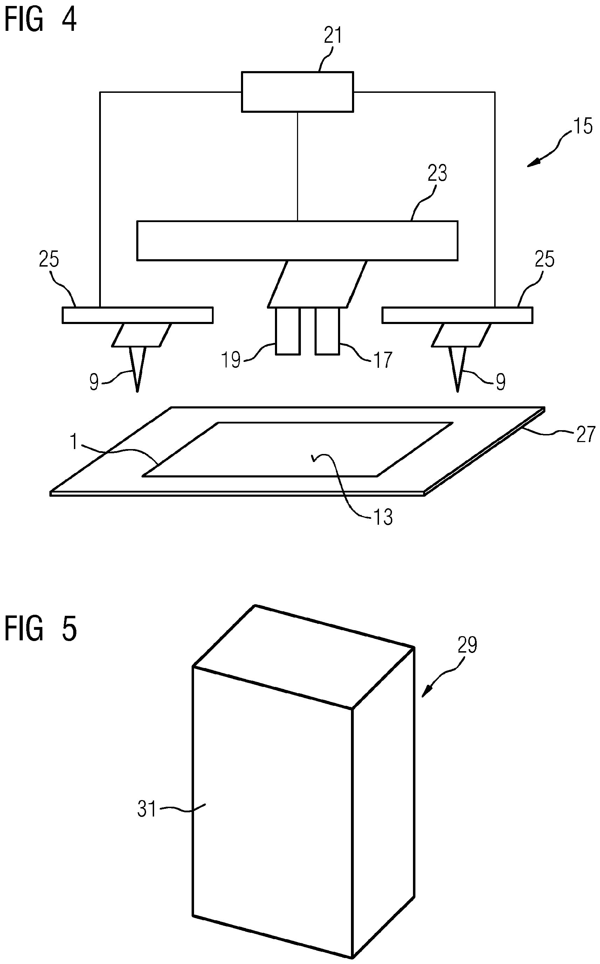

Figur 4 zeigt schematisch eine Fertigungsvorrichtung 15 zur Herstellung einer Leiterbahn 3 auf einer Trägerplatte 1 gemäß dem anhand von Figur 2 beschriebenen Verfahren.

Die Fertigungsvorrichtung 15 umfasst einen Drucker 17 zum Drucken der elektrisch leitfähigen Paste 4 auf die Trägerplatte 1, einen Vorhärter 19 zum Vorhärten auf die Trägerplatte 1 gedruckter Paste 4, eine anhand von Figur 3 beschriebene Bestromungsvorrichtung 5 zum Bestromen einer auf die Trägerplatte 1 gedruckten vorgehärteten Paste 4, eine Messvorrichtung 7 zum Erfassen eines elektrischen Widerstands der auf die Trägerplatte 1 gedruckten Paste 4 während des Bestromens der Paste 4 und eine Steuereinheit 21. Ferner weist die Fertigungsvorrichtung 15 eine erste Verfahrvorrichtung 23 zum Bewegen des Druckers 17 und des Vorhärters 19 und für jedes Kontaktelement 9 der Bestromungsvorrichtung 5 eine zweite Verfahrvorrichtung 25 zum Bewegen des Kontaktelements 9 auf. Zum Herstellen einer Leiterbahn 3 wird die Trägerplatte 1 auf einem Bearbeitungstisch 27 angeordnet, wobei die zu bedruckende Oberfläche 13 der Trägerplatte 1 der Fertigungsvorrichtung 15 zugewandt ist.

Der Drucker 17 ist beispielsweise als ein 3D-Drucker ausgebildet.

Der Vorhärter 19 weist beispielsweise eine Strahlungsquelle elektromagnetischer Strahlung, z. B. einen Laser, zum Bestrahlen der Paste 4 mit elektromagnetischer Strahlung entlang des vorgegebenen Leiterbahnverlaufs auf.

Mit der ersten Verfahrvorrichtung 23 sind der Drucker 17 und der Vorhärter 19 dreidimensional bewegbar, so dass sie zu jedem Punkt der Oberfläche 13 der Trägerplatte 1 bewegt werden können.

Mit jeder zweiten Verfahrvorrichtung 25 ist ein Kontaktelement 9 der Bestromungsvorrichtung 5 dreidimensional bewegbar, so dass es zu jedem Punkt der Oberfläche 13 der Trägerplatte 1 bewegt werden kann.

Mit der Steuereinheit 21 werden der Widerstandswert für den elektrischen Widerstand der Leiterbahn und der Leiterbahnverlauf der Leiterbahn auf der Trägerplatte vorgegeben und der Drucker 17, der Vorhärter 19, die Bestromungsvorrichtung 5 und die Verfahrvorrichtungen 23, 25 gesteuert. Insbesondere steuert die Steuereinheit 21 das Bewegen des Druckers 17 entlang des vorgegebenen Leiterbahnverlaufs und das Ausgeben der Paste 4 durch den Drucker 17, das Bewegen des Vorhärters 19 entlang des vorgegebenen Leiterbahnverlaufs und das Vorhärten der auf die Trägerplatte 1 gedruckten Paste 4 durch den Vorhärter 19 sowie das Positionieren der Kontaktelemente 9 und das Bestromen der auf die Trägerplatte 1 gedruckten vorgehärteten Paste 4 bis der elektrische Widerstand der Paste 4 den vorgegebenen Widerstandswert erreicht.

Figur 5 zeigt eine perspektivische Darstellung eines Schaltschranks 29. Der Schaltschrank 29 weist eine Backplane 31 zum elektrischen Verbinden elektrischer Bauelemente auf. Die Backplane 31 bildet eine Rückwand des Schaltschranks 29 und weist eine Trägerplatte 1 mit einer Leiterbahn 3 auf, die mit dem erfindungsgemäßen Verfahren gefertigt ist.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zur Herstellung einer Leiterbahn (3) auf einer Trägerplatte (1), wobei
- ein Widerstandswert für einen elektrischen Widerstand der Leiterbahn (3) und ein Leiterbahnverlauf der Leiterbahn (3) auf der Trägerplatte (1) vorgegeben werden,
- eine elektrisch leitfähige Paste (4) entlang des vorgegebenen Leiterbahnverlaufs auf die Trägerplatte (1) aufgebracht wird,
- die auf die Trägerplatte (1) aufgebrachte Paste (4) durch Erwärmung vorgehärtet wird und
- die vorgehärtete Paste (4) ausgehärtet wird, indem sie elektrisch bestromt wird,
- wobei während des Bestromens der Paste (4) fortlaufend ein elektrischer Widerstand der aushärtenden Paste (4) erfasst wird und die Bestromung beendet wird, wenn der erfasste elektrische Widerstand den vorgegebenen Widerstandswert erreicht.

2. Verfahren nach Anspruch 1, wobei die elektrisch leitfähige Paste (4) mit einem additiven Fertigungsverfahren auf die Trägerplatte (1) aufgebracht wird.

3. Verfahren nach Anspruch 1, wobei das additive Fertigungsverfahren ein 3D-Druck ist.

4. Verfahren nach einem der Ansprüche 1 bis 3, wobei die auf die Trägerplatte (1) aufgebrachte Paste (4) mit elektromagnetischer Strahlung, insbesondere mit einem Laserstrahl, entlang des Leiterbahnverlaufs vorgehärtet wird.

5. Verfahren nach einem der Ansprüche 1 bis 4, wobei die Paste (4) zum Bestromen mit zwei bewegbaren elektrisch leitfähigen Kontaktelementen (9) kontaktiert wird, zwischen denen eine elektrische Spannung angelegt wird.

6. Fertigungsvorrichtung (15) zur Herstellung einer Leiterbahn (3) auf einer Trägerplatte (1) gemäß einem Verfahren nach einem der vorhergehenden Ansprüche, die Fertigungsvorrichtung (15) umfassend
- einen Drucker (17) zum Drucken der elektrisch leitfähigen Paste (4) auf die Trägerplatte (1),
- einen Vorhärter (19) zum Vorhärten auf die Trägerplatte (1) gedruckter Paste (4),
- eine Bestromungsvorrichtung (5) zum Bestromen einer auf die Trägerplatte (1) gedruckten vorgehärteten Paste (4),
- eine Messvorrichtung (7) zum Erfassen eines elektrischen Widerstands der auf die Trägerplatte (1) gedruckten Paste (4) während des Bestromens der Paste (4) und
- eine Steuereinheit (21) zum Steuern des Druckers (17), des Vorhärters (19) und der Bestromungsvorrichtung (5).

7. Fertigungsvorrichtung (15) nach Anspruch 6, wobei der Drucker (17) ein 3D-Drucker ist.

8. Fertigungsvorrichtung (15) nach Anspruch 6 oder 7, wobei der Vorhärter (19) eine Strahlungsquelle elektromagnetischer Strahlung, insbesondere einen Laser, zum Bestrahlen der Paste (4) mit elektromagnetischer Strahlung entlang des vorgegebenen Leiterbahnverlaufs aufweist.

9. Fertigungsvorrichtung (15) nach einem der Ansprüche 6 bis 8, wobei die Bestromungsvorrichtung (5) zum Kontaktieren einer auf die Trägerplatte (1) gedruckten vorgehärteten Paste (4) zwei bewegbare elektrisch leitfähige Kontaktelemente (9) aufweist, zwischen denen eine elektrische Spannung anlegbar ist.

10. Fertigungsvorrichtung (15) nach einem der Ansprüche 6 bis 9, wobei mit der Steuereinheit (21)
- der Widerstandswert für den elektrischen Widerstand der Leiterbahn (3) und der Leiterbahnverlauf der Leiterbahn (3) auf der Trägerplatte (1) vorgebbar sind,
- der Drucker (17) zum Drucken der elektrisch leitfähigen Paste (4) entlang des vorgegebenen Leiterbahnverlaufs auf die Trägerplatte (1) steuerbar ist,
- der Vorhärter (19) zum Vorhärten der auf die Trägerplatte (1) gedruckten Paste (4) entlang des vorgegebenen Leiterbahnverlaufs steuerbar ist und
- die Bestromungsvorrichtung (5) zum Bestromen der auf die Trägerplatte (1) gedruckten vorgehärteten Paste (4) steuerbar ist,
- wobei die Bestromung der Paste (4) beendet wird, wenn der von der Messvorrichtung (7) erfasste elektrische Widerstand der Paste (4) den vorgegebenen Widerstandswert erreicht.

11. Backplane (31) zum elektrischen Verbinden elektrischer Bauelemente, die Backplane (31) umfassend eine Trägerplatte (1) mit einer Leiterbahn (3), die mit einem Verfahren nach einem der Ansprüche 1 bis 5 gefertigt ist.

12. Schaltschrank (29) mit einer gemäß Anspruch 11 ausgebildeten Backplane (31).
